# EUROPEAN PATENT SPECIFICATION

(11) **EP 0 276 683 B1**
(45) Date of publication and mention of the grant of the patent: **30.03.1994**
(21) Application number: 88100331.3
(22) Date of filing: 12.01.1988
(51) Int. Cl.: H01L 31/08, H01L 31/02, H01L 27/14

(54) **Photoelectric conversion device**
Photoelektrische Wandlereinrichtung
Dispositif de conversion photoélectrique

(30) Priority: 14.01.1987 JP 4866/87
(43) Date of publication of application: 03.08.1988
(73) Proprietor: HITACHI, LTD., Chiyoda-ku, Tokyo 100 (JP); NIPPON HOSO KYOKAI, Tokyo 150 (JP)
(72) Inventor: Ishioka, Sachio, Burlingame, CA 94010 (US); Takasaki, Yukio, Asao-ku Kawasaki-shi (JP); Hirai, Tadaaki, Koganei-shi (JP); Tsuji, Kazutaka, Hachioji-shi (JP); Makishima, Tatsuo, Nozaki-3-chome Mitaka-shi (JP); Nonaka, Yasuhiko, Mobara-shi (JP); Kawamura, Tatsuro, Tama-shi (JP); Yamashita, Takashi, Sagamihara-shi (JP); Taketoshi, Kazuhisa, Sagamihara-shi (JP); Shidara, Keiichi, Tama-shi (JP); Ando, Fumihiko, Midori-ku Yokohama (JP); Tanioka, Kenkichi, Setagaya-ku Tokyo (JP)
(74) Representative: Strehl Schübel-Hopf Groening & Partner

(56) References cited:
- EP-A- 0 040 076
- EP-A- 0 255 246
- US-A- 4 581 476
- IEEE TRANSACTIONS ON ELECTRON DEVICES, vol. ED-32, no. 11, November 1985, pages 2192-2196, New York, US; B.S. WU et al.: "Amorphous silicon phototransistor on a glass substrate"
- INTERNATIONAL ELECTRON DEVICES MEETING 1979, Washington, D.C., 3th - 5th December 1979, pages 134-136, New York, US; T. TSUKADA et al.: "New solid-state image pickup devices using photosensitive chalcogenide glass film"
- JAPANESE JOURNAL OF APPLIED PHYSICS, vol. 21, no. 2, part 1, February 1982, pages 213-223, Tokyo, JP; E. MARUYAMA: "Amorphous built-in-field effect photoreceptors"
- PATENT ABSTRACTS OF JAPAN, vol. 7, no. 239 (E-206)[1384], 25th October 1983 ; & JP-A-58130578
- PATENT ABSTRACTS OF JAPAN, May 25th 1982, vol. 6, no. 87 (E-108)(965) ; & JP-A-5721876

## Description

### BACKGROUND OF THE INVENTION

### Field of the Invention

The present invention generally relates to a photoelectric conversion device for converting a photo signal into an electric signal, and particularly relates to a photoelectric conversion device which uses an amorphous semiconductor having a charge multiplication action so as to realize high sensitivity. The photoelectric conversion device according to the present invention includes an image pickup device of the photoconductive film lamination type, for example, a one-dimensional image sensor, a two-dimensional image sensor, etc.

### Description of the Related Art

Conventionally, as the photoelectric conversion device mainly constituted by an amorphous semiconductor, known are such a photocell and a one-dimensional image sensor as disclosed in JP-A-52-144992, and such a two-dimensional image sensor (hereinafter, referred to as "solid-state photoconductive device of the photoconductive film lamination type") which is constituted by a combination of a solid state drive circuit and an amorphous photoconductive material as disclosed in JP-A-49-24619.

As photoelectric conversion portions of these photoelectric conversion devices, there are known two types: one which itself has no multiplication function and the other which itself has a multiplication function.

With regard to the available photocells, one-dimensional image sensors and solid-state imagers of the photoconductive film lamination type, the most of them belong to the former type i.e., the one which itself has no multiplication function, and the photoelectric conversion portion of the former type is further classified into two types depending upon whether charge injection from the electrode thereof is present or not. A first one is of a so-called blocking type in which the charge injection from the electrode thereof into the photoconductive film is blocked and a second one is of an injection type in which such charge injection is allowed. Of these two types, the blocking type devices are generally utilized for a case wherein a good photo-response is required. In this case, however, it is impossible to derive signal charges greater than the number of carriers produced by the incident light. That is, the gain of photoelectric conversion is 1 at best. In the injection type device, on the other hand, a high sensitization of a gain larger than 1 can be realized because, in principle, charges more than the number of the incident photons can be derived into an external circuit. In this system in which charges are partly injected into the inside of a sensor, however, the photo-response is considerably deteriorated.

With regard to the photoelectric conversion devices of the type in which a photoelectric conversion portion thereof has a multiplication function, the following devices have been heretofore proposed. A first type device is of the type which comprises an injection type electrode and a gate which opens in response to a light in the photoelectric conversion portion thereof. As devices belonging to this first type device, for example, there has been proposed an image pickup device in which an amorphous semiconductor photoconductive layer having phototransistor characteristics and a read-out circuit are laminated one on the other, as disclosed in JP-A-61-222383, and also, there has been proposed a device utilizing a transistor of the electrostatic induction type as discussed in IEEE TRANSACTION ON ELECTRON DEVICES (vol. ED 22, 1975, pages 185-197). Either of these devices basically belongs to the injection type and the device utilizing amorphous semiconductor suffers from disadvantages such as a slow response, in particular. Further, in the transistor of the electrostatic induction type, an amplification portion is provided therein for every picture element, and therefore it is necessary to provide a complicated process so as to make amplification factors for the respective picture elements agree with each other. As a second type device, there has been proposed a system such as the one disclosed in JP-A-57-21876 in which p⁺/πp/n/n⁺ junctions are formed in amorphous silicon containing hydrogen in the same manner as in crystal silicon to thereby generate an avalanche action at the p/n junction so as to perform signal amplification. In this system, a good photo-respense is obtained because the structure of this system is such that the charge injection from the electrode into the photoelectric conversion portion is blocked, while since the depletion layer thereof is not widened much, it suffers from a disadvantage that a satisfactory amplification factor is not always obtained.

As has been mentioned, the performance of presently available photoelectric conversion devices such as a photocell, a one-dimensional image sensor and a solid state imager of the photoconductive layer lamination type is not satisfactory and there has been a strong demand for an increased sensitivity and an improved performance.

### SUMMARY OF THE INVENTION

It is therefore an object of the present invention to solve the foregoing conventional problems.

Namely, it is an object of the present invention to provide a photoelectric conversion device of high sensitivity such as a gain of photoelectric conversion larger than 1 and having a good photo response.

It is a further object of the present invention to provide a photoelectric conversion device which is simple in structure and easy in manufacturing.

It is still another object of the present invention to provide a photoelectric conversion device having a small dark current.

It is a still further object of the present invention to provide a photoelectric conversion device having a homogeneous photoconductive layer which is easily increased in area.

The above objects are achieved by the photoelectric conversion device as featured in claim 1.

The inventors of this application have carried out various experiments as to the amorphous semiconductor material and found that when a strong electric field is applied to the amorphous semiconductor material, a charge multiplication action (an avalanche effect) is caused inside the amorphous semiconductor material. EP-A-0255246 which belongs to the state of the art according to Article 54(3)EPC concerns a photoelectric conversion device comprising an amorphous photoconductive layer such as Se coated with a hole blocking layer of CeO₂, operated in the avalanche mode.

According to the present invention having the foregoing structure using such an amorphous semiconductor, it is possible to obtain a photoelectric conversion device which is excellent in photo-response and which has a gain larger than 1 to make the sensitivity high.

### BRIEF DESCRIPTION OF THE DRAWINGS

The present invention will be apparent from the following detailed description taken in conjunction with the accompanying drawings, in which:
Fig. 1 is a diagram showing a device formed to confirm the charge multiplication action of the amorphous semiconductor material utilized according to the present invention;
Fig. 2 is a diagram for explaining the charge multiplication action of the amorphous semiconductor material utilized according to the present invention;
Fig. 3 is a schematic diagram showing an embodiment of the photoelectric conversion device according to the present invention;
Figs. 4A and 4B are diagrams showing another photoelectric conversion device;
Fig. 5 is a diagram showing a further embodiment of the photoelectric conversion device according to the present invention; and
Fig. 6 is a diagram showing a still further embodiment of the photoelectric conversion device according to the present invention.

### DESCRIPTION OF THE PREFERRED EMBODIMENTS

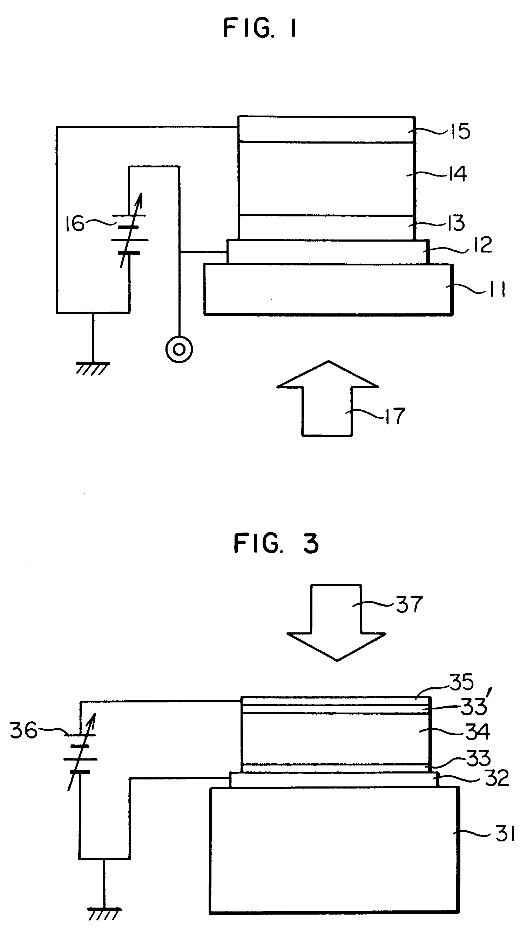

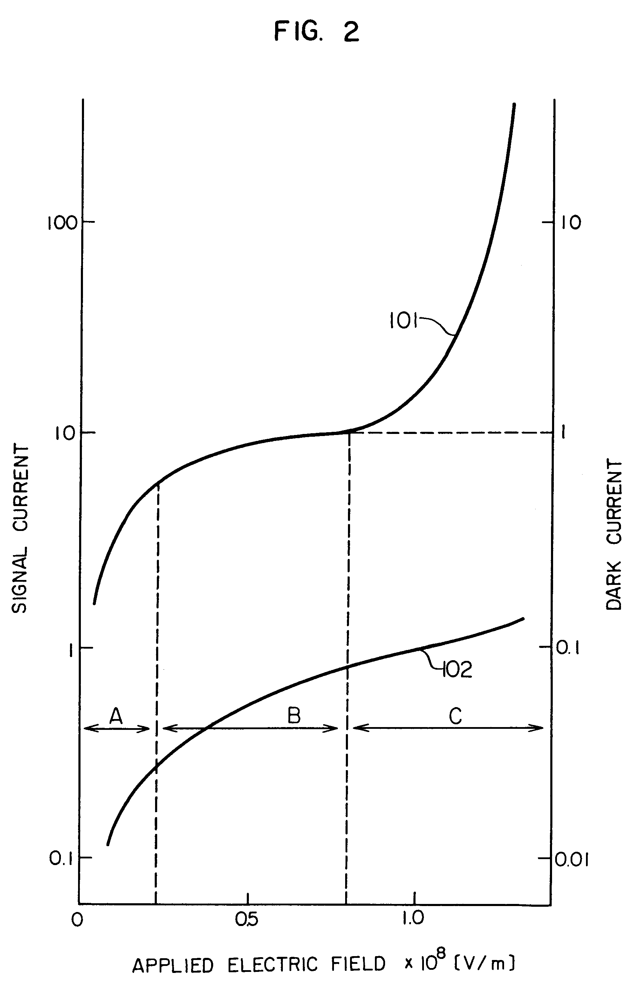

First, referring to Figs. 1 and 2, the charge multiplication action of the amorphous semiconductor will be described. In order to confirm the charge multiplication action of the amorphous semiconductor, a device having such a structure as shown in Fig. 1 was produced. A light-transmissible electrode 12, a thin cerium oxide layer 13, an amorphous selenium layer 14, and an Au electrode 15 were laminated in order on a light-transmissible glass substrate 11. The thus arranged device was connected to a power source 16 for applying an electric field so that the light-transmissible electrode 12 had positive electric potential relative to the Au electrode 15, and the device was irradiated with incident light 17 from the glass substrate 11 side.

In Fig. 2, curves 101 and 102 show the relation between a signal current and an applied voltage and the relation between a dark current and the applied voltage in this device respectively. In the drawing, the applied voltage is represented by the electric field intensity (the ordinate).

The thin cerium oxide layer 13 is formed so as to prevent positive holes from being injected into the amorphous selenium layer 14 from the light-transmissible electrode 12. Further, since the quantity of electrons injected into the amorphous selenium layer 14 from the Au electrode 15 is very small, this device operates as a so-called device of the charge-injection blocking type.

As seen from Fig. 2, the curve 101 showing the relation between the signal current and the applied voltage is formed of three regions A, B and C.

In the region A, the incident light 17 passed through the light-transmissible glass substrate 11 is absorbed in the amorphous selenium layer 14 to thereby generate electron-hole pairs, and the electron-hole pairs are partly separated from each other by the applied voltage, so that the electrons move toward the light-transmissible electrode 12 and the holes reach the Au electrode 15 so as to be derived into an external circuit. In this electric field region, although the signal current increases as the intensity of electric field is made high, the signal current is exceedingly affected by recombination of the electrons with the holes, so that the gain of the device is not larger than 1.

When the applied voltage is further made higher so as to be in the region B of Fig. 2, almost all the electron-hole pairs generated by the incident light 17 are separated from each other by means of the electric field, so that the electrons and the holes run toward the light-transmissible electrode 12 and the Au electrode 15 respectively without being recombined with each other.

In the region B, the signal current begins to show a tendency to saturate. However, since the signal current becomes maximum when the incident light 17 is entirely converted into electron-hole pairs so as to be derived as the signal current, and therefore the gain of the photoconductive film becomes 1 at the most. The photocell, the one-dimensional image sensor, and the solid-state photoconductive device of the photoconductive film lamination type which have been described in the foregoing item "Description of the Related Art" are made to operate in the foregoing region A or B.

The inventors of this application have found the fact that in the case where the photoconductive film is formed by amorphous selenium, if the applied electric field is made further stronger from the foregoing region B, there occurs such a phenomenon that the signal current increases rapidly so that the gain becomes larger than 1. The signal current increase phenomenon in the amorphous selenium layer has not been made sufficiently clear yet. However, the charge multiplication action in the photoelectric conversion device according to the present invention is different from that caused by charge injection which has been explained in the foregoing item "Description of the Related Art", because the increase of the dark current is not recognized in the region C as seen from the curve 102 of Fig. 2, and when the film thickness of the amorphous selenium layer is increased, the multiplication factor of the signal current with respect to the same intensity of electric filed increases.

Utilizing such a phenomenon that a charge multiplication action is generated in the inside of an amorphous selenium layer when a strong electric field is applied to the amorphous selenium layer, a high-sensitive photoelectric conversion device having a gain larger than 1 can be obtained without deteriorating the good photo-response of the photoelectric conversion device having a blocking type structure if an amorphous semiconductor layer which can generate such a charge multiplication action is put on a signal read-out circuit.

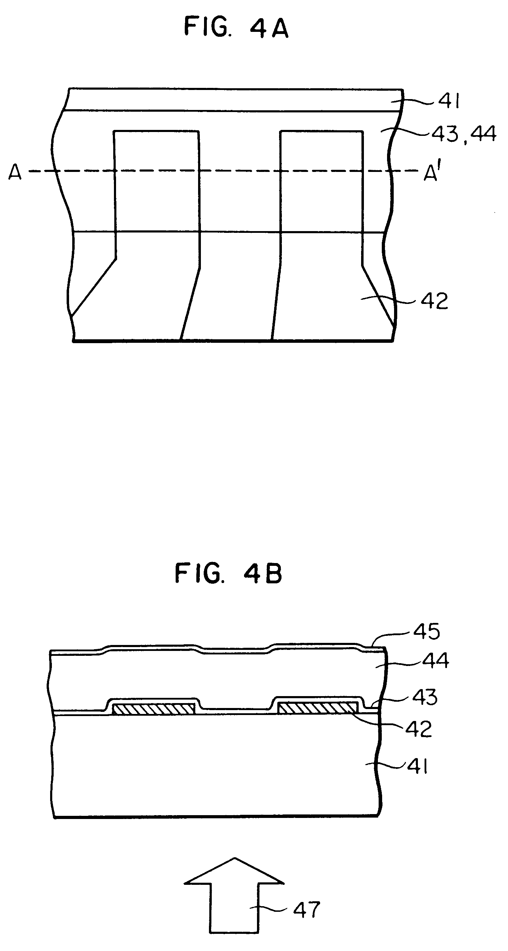

Fig. 3 is a diagram showing an embodiment of the principle of a photoelectric conversion device according to the present invention. The photoelectric conversion device is basically constituted by a substrate 31 provided with a signal-reading scanning circuit formed thereon, a signal reading electrode 32, an amorphous selenium layer 34, and a light-transmissible conductive film 35. If a sufficient rectification contact can not be obtained between the signal reading electrode 32 or the counter electrode 35 and the amorphous selenium layer 34, an auxiliary rectification contact layers 33, 33ʹ may be interposed therebetween so as to strengthen the function of rectification contact.

An electric field corresponding to the region C of Fig. 2 is applied to the photoelectric conversion device having the structure of Fig. 3 by using an external voltage application means 36 in the direction for making the light-transmissible conductive film 35 have positive electric potential. When the photo-electric conversion device is irradiated with incident light from the light-transmissible conductive film 35 side in this state, the incident light 37 is absorbed in the amorphous selenium layer 34 to thereby generate electron-hole pairs therein. Of those electron-hole pairs, the electrons flow toward the light-transmissible conductive film 35, and, on the other hand, the holes run toward the signal reading electrode 32 through the amorphous selenium layer 34.

Accordingly, if the amorphous selenium layer 34 is made thick so that the charge multiplication action is caused when the holes run through the amorphous selenium layer 34 under the high electric field to thereby obtain desired characteristics, multiplication of charges is generated to thereby obtain high sensitivity which can make the gain larger than 1 while maintaining the good photo-response.

In a crystalline semiconductor material, generation of such a charge multiplication action has been already known as an avalanche amplification phenomenon. In the crystalline semiconductor material, however, microplasmas are generated and a large dark current of 10⁻⁹ A/mm² flows. Therefore, when a sectional area of the device is large, there has been a problem that the dark current can not be suppressed to a small value. Accordingly, the crystalline semiconductor material has never been practically used for a two-dimensional photoelectric conversion device such as an image pickup device or the like. In the amorphous semiconductor material, on the other hand, it has been generally considered that the charge multiplication action as described above is not caused in a semiconductor layer itself because of its internal defects. However, as the results of various experiments and investigations, the inventors of this application have found the fact that the charge multiplication action exists in amorphous selenium and a dark current in the amorphous selenium is only one percent or less of that in the crystalline semiconductor material even in the case of a large sectional area of the amorphous selenium.

Further, as the results of detailed investigations, the inventors of this application have found that the charge multiplication action in the amorphous selenium is caused by positive holes very remarkably, while caused by electrons slightly. Therefore, in the case where the foregoing charge multiplication action is utilized for the photoelectric conversion device, the multiplication of charges can be efficiently performed with low noises if an electric field is applied so as to make mainly the hole run in a film. Further, the device according to the present invention which uses amorphous selenium is remarkably effective in that the amorphous selenium can be easily formed as a homogeneous thin film having a large area and can be deposited on a signal reading circuit substrate through a simple process, and in that a uniform multiplication factor can be obtained in the amorphous selenium.

Although the above description has been made as to the photoelectric conversion device using the charge multiplication action in the amorphous selenium, it has been found that the foregoing effects of the charge multiplication action can be held even when arsenic and/or germanium is added to the amorphous selenium for the purpose of increasing thermal stability of the latter. Further, for example, tellurium may be added for the purpose of increasing the sensitivity to light of a long wavelength. Moreover, it is not always necessary to form the photoconductive layer by a single photoconductive film of amorphous selenium, but the device may be provided with a lamination of photoconductive layer constituted by two kinds or more of amorphous semiconductor layers having the same charge multiplication action as that of the amorphous selenium. Further, it is not necessary to form the whole of the photoconductive layer by only the amorphous semiconductor, but may be a lamination of crystal and amorphous semiconductor layers. That is, in the photoelectric conversion device according to the present invention, it is necessary that an amorphous semiconductor is used at least as a part of layers constituting the photoconductive layer and the charge multiplication action is caused in the inside of the amorphous semiconductor layer by application of a strong electric field so as to increase the sensitivity of the device. As seen from Fig. 2, in the amorphous selenium, avalanche multiplication is generated under the electric field intensity of about 8 x 10⁹ ∼ 2 x 10¹⁰ V/m.

Figs. 4A and 4B are diagrams for explaining an one-dimensional elongated image sensor, Fig. 4A being a schematic plan showing a portion of the example, Fig. 4B being a cross section taken along dotted line A-Aʹ of Fig. 4A.

A light-transmissible conductive film is formed on a glass substrate 41, and divided by a photoetching process so as to form reading electrodes 42 separated from each other. Next, a CeO₂ thin film 43 acting as an auxiliary rectification contact layer and amorphous selenium having a thickness of 0.5 - 6 µm acting as a photoconductive film 44 are formed by vacuum evaporation over the reading electrodes 42 through a mask having elongated holes. Next, a conductive film 45 is deposited on the amorphous selenium layer by evaporation, sputtering, CVD, or the like so as to form a photoelectric conversion portion. Further, the reading electrodes of the photoelectric conversion portion are connected to a scanning circuit formed on the substrate 41 by bonding or any other suitable means, thereby obtaining a one-dimensional elongated image sensor.

The present invention will be described more in detail with respect to further embodiments hereunder.

### EXAMPLE 1

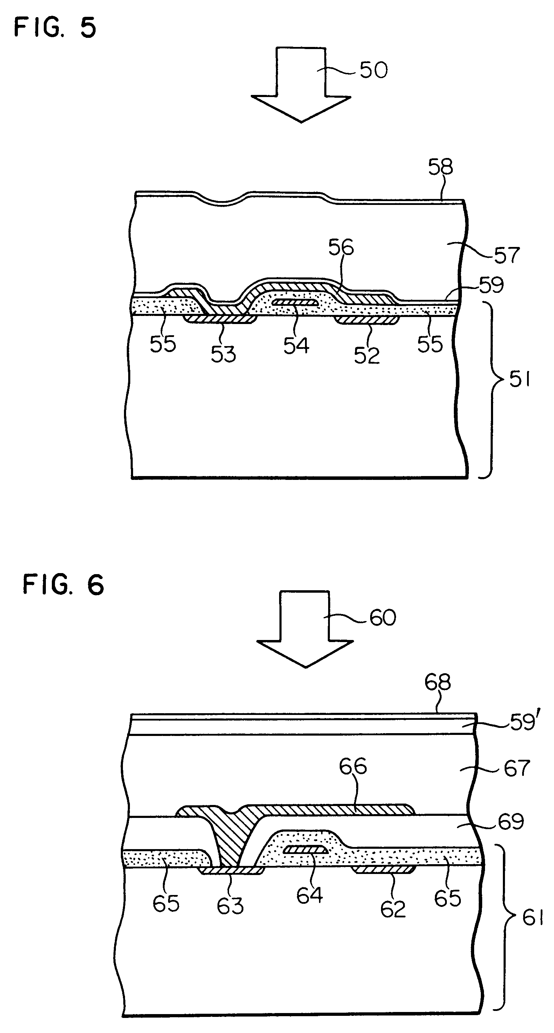

Fig. 5 shows an embodiment in the case where the present invention is applied to a solid-state image pickup device.

As a lower substrate having signal reading and transferring functions, a monocrystal silicon IC substrate 51 provided at its surface with a two-dimensionally disposed MOS-type switch is used. The silicon IC substrate 51 is produced through the same process as that in the case of the conventional solid-state image pickup device. The silicon IC substrate 51 is provided with a source electrode 52, a drain electrode 53, a gate electrode 54, insulating layers 55, and an electrode 56 for reading a signal from a photoconductive film. In order to block the carrier injection from the electrode 56, a layer 59 is provided.

An amorphous semiconductor layer 57 having a thickness of 0.5 ∼ 6 µm and containing selenium as a main component, arsenic, and tellurium is formed on the foundation substrate 51 formed in such a manner as described above through a vacuum evaporation process. In formation of the film, Se, As₂Se₃, and Te are simultaneously evaporated from deposition sources separated from each other so as to be deposited on the substrate 51. Further, a light-transmissible conductive film 58 is deposited on the amorphous semiconductor layer 57 by evaporation, sputtering, CVD, or the like to thereby obtain a solid-state image pickup device.

### EXAMPLE 2

Fig. 6 shows another embodiment in the case where the present invention is applied to a solid-state image pickup device. Similarly to Example 1, as a lower substrate having signal reading and transferring functions, a monocrystal silicon IC substrate 61 provided at its surface with a two-dimensionally disposed MOS-type switching element is used. That is, a source electrode 62, a drain electrode 63 and a gate electrode 64 insulated in a predetermined manner by an insulating layer 65 are formed on a base layer of the silicon monocrystal.

Example 2 is different from Example 1 in that an insulating layer 69 of PIQ or the like is formed on the substrate 61 having such a structure formed as described above. The insulating layer 69 is formed to have a thickness of, for example, about several µm. The thickness should be suitably determined in accordance with the evenness of the foundation substrate 61. The insulating layer 69 is formed to make a surface of a signal reading electrode 66 formed thereon flat so that avalanche multiplication can be generated uniformly in a photoconductive film 67, in other words, so that the intensity of electric field can be generated uniformly in the inside of the photoconductive film 67. It is sufficient if the intensity of electric field inside the photoconductive layer 67 is made uniform mainly in an operation region corresponding to an upper portion of the electrode 66.

In this example, a charge-injection prevention layer 59ʹ of CeO₂ is formed by a vacuum evaporation process after the photoconductive layer 67 has been formed. This layer 59ʹ is provided to prevent holes from being injected from a light-transmissible electrode 68 at the incident side of a light signal 60 into the photoconductive layer 67.

Although the MOS-type scanning substrate is used as the lower substrate in Examples 2 and 3, it is a matter of course that a CCD-type scanning substrate of the system in which charge carriers stored in electric potential wells by charge transfer are successively transferred so as to be read into an external circuit may be used in place of the MOS-type scanning substrate.

When an electric field of an intensity not smaller than 8 x 10⁹ V/m is applied to the amorphous selenium photoconductive film of the photoelectric conversion device obtained in the foregoing Examples 1, and 2 to cause the amorphous selenium photoconductive film to operate, signal amplification is caused in the amorphous semiconductor layer, and if the electric filed is made to have an intensity of, for example, 1.2 x 10¹⁰ V/m, an output having a gain not smaller than 10 relative to a quantity of incident light can be obtained.

## Claims

1. A photoelectric conversion device operated in the avalance mode comprising
a semiconductor substrate (51; 61) having electric circuits (52...55; 62...65) and at least one electrode (56; 66) for reading electric signals,
a photoconductive layer (57; 67) formed thereon and made of amorphous semiconductor material generating electric signals in accordance with external photo signals (50; 60),
a conductive layer (58; 68) formed on said photoconductive layer (57; 67), and
a charge-injection blocking layer (59; 59') formed between said photoconductive layer (57; 67) and said electrode (56) or said conductive layer (68) to prevent the injection of carriers into said photoconductive layer (57; 67),
wherein said photoconductive layer (57; 67) is exposed to an electric field of an intensity that causes charge multiplication in the photoconductive layer (57; 67).

2. The device of claim 1, wherein said electric field has an intensity of no less than 8 x 10⁹ V/m.

3. The device of claim 1 or 2, wherein an insulating layer (69) is formed on said substrate (61) to flatten the surface of the signal reading electrode (66).

4. The device of any of claims 1 to 3, wherein said electric circuits have at least one FET which has a first, a second and a third electrode (52, 53, 54; 62, 63, 64), carriers flowing between said first and second electrodes (52, 53; 62, 63) are controlled by an electric field from said third electrode (54, 64), and one of said first and second electrodes (53, 63) is connected with said at least one signal reading electrode (56, 66).

5. The device of any of claims 1 to 4, wherein said photoconductive layer is mainly made of selenium.

6. The device of claim 5, wherein said photoconductive layer contains arsenic and/or germanium or tellurium.

7. The device of any of claims 1 to 4, wherein said photoconductive layer is formed of a plurality of amorphous semiconductor layers.

8. The device of claim 7, wherein said photoconductive layer comprises an amorphous selenium layer and an amorphous silicon layer, the latter optionally containing hydrogen.

## Patentansprüche

1. Im Avalanche-Modus betriebene photoelektrische Wandlereinrichtung, umfassend:
ein Halbleitersubstrat (51; 61) mit elektrischen Schaltungen (52...55; 62...65) und mindestens einer Elektrode (56; 66) zum Auslesen von elektrischen Signalen,
eine darauf ausgebildete photoleitfähige Schicht (57; 67) aus amorphem Halbleitermaterial, die entsprechend externen Photosignalen (50; 60) elektrische Signale erzeugt,
eine auf der photoleitfähigen Schicht (57; 67) ausgebildete leitfähige Schicht (58; 68), und
eine zwischen der photoleitfähigen Schicht (57; 67) und der Elektrode (56) oder der leitfähigen Schicht (68) ausgebildete Ladungsträger-Injektionsblockierschicht (59; 59'), die die Injektion von Ladungsträgern in die photoleitfähige Schicht (57; 67) verhindert,
wobei die photoleitfähige Schicht (57; 67) einem elektrischen Feld einer Intensität ausgesetzt ist, die in der photoleitfähigen Schicht (57; 67) eine Ladungsvervielfachung bewirkt.

2. Einrichtung nach Anspruch 1, wobei das elektrische Feld eine Intensität von nicht weniger als 8 x 10⁹ V/m hat.

3. Einrichtung nach Anspruch 1 oder 2, wobei auf dem Substrat (61) eine Isolierschicht (69) ausgebildet ist, um die Oberfläche der Signal-Ausleseelektrode (66) zu glätten.

4. Einrichtung nach einem der Ansprüche 1 bis 3, wobei die elektrischen Schaltungen mindestens einen FET mit einer ersten, einer zweiten und einer dritten Elektrode (52, 53, 54; 62, 63, 64) enthalten, wobei die zwischen der ersten und der zweiten Elektrode (52, 53; 62, 63) fließenden Ladungsträger durch ein elektrisches Feld von der dritten Elektrode (54; 64) gesteuert sind, und wobei die erste oder die zweite Elektrode (53; 63) mit der besagten mindestens einen Signal-Ausleseelektrode (56; 66) verbunden ist.

5. Einrichtung nach einem der Ansprüche 1 bis 4, wobei die photoleitfähige Schicht hauptsächlich aus Selen besteht.

6. Einrichtung nach Anspruch 5, wobei die photoleitfähige Schicht Arsen und/oder Germanium oder Tellur enthält.

7. Einrichtung nach einem der Ansprüche 1 bis 4, wobei die photoleitfähige Schicht aus mehreren amorphen Halbleiterschichten gebildet ist.

8. Einrichtung nach Anspruch 7, wobei die photoleitfähige Schicht eine amorphe Selenschicht und eine amorphe Siliziumschicht enthält, wobei die letztere wahlweise Wasserstoff enthält.

## Revendications

1. Dispositif de conversion photoélectrique fonctionnant dans le mode à avalanche, comprenant
un substrat semiconducteur (51; 61) possédant des circuits électriques (52...55; 62...65) et au moins une électrode (56; 66) pour lire des signaux électriques,
une couche photoconductrice (57;67) formée sur lesdits circuits et la ou lesdites électrodes et constituée par un matériau semiconducteur amorphe et produisant des signaux électriques en fonction de photosignaux extérieurs (50;60),
une couche conductrice (58;68) formée sur ladite couche photoconductrice (57; 67) et
une couche (59; 59') de blocage d'injection de charges, formée entre ladite couche photoconductrice (57; 67) et ladite électrode (56) ou ladite couche conductrice (68) pour empêcher l'injection de porteurs dans ladite couche photoconductrice (57; 67),
dans lequel ladite couche photoconductrice (57; 67) est exposée à un champ électrique possédant une intensité qui provoque une multiplication de charges dans la couche photoconductrice (57; 67).

2. Dispositif selon la revendication 1, dans lequel ledit champ électrique possède une intensité non inférieure à 8 x 10⁹ V/m.

3. Dispositif selon la revendication 1 ou 2, dans lequel une couche isolante (69) est formée sur ledit substrat (61) de manière à aplanir la surface de ladite électrode (66) de lecture de signaux.

4. Dispositif selon l'une quelconque des revendications 1 à 3, dans lequel lesdits circuits électriques possèdent au moins un transistor FET qui comporte des première, seconde et troisième électrodes (52, 53, 54; 62, 63, 64), des porteurs circulant entre lesdites première et seconde électrodes (52, 53; 62, 63) sont commandés par un champ électrique produit par ladite troisième électrode (54; 64), et l'une desdites première et seconde électrodes (53, 63) est raccordée à la ou les électrodes(56, 66) de lecture de signaux.

5. Dispositif selon l'une quelconque des revendications 1 à 4, dans lequel ladite couche photoconductrice est formée principalement de sélénium.

6. Dispositif selon la revendication 5, dans lequel ladite couche photoconductrice contient de l'arsenic et/ou du germanium ou du tellure.

7. Dispositif selon l'une quelconque des revendications 1 à 4, dans lequel ladite couche photoconductrice est formée par une pluralité de couches semiconductrices amorphes.

8. Dispositif selon la revendication 7, dans lequel ladite couche photoconductrice comprend une couche de sélénium amorphe et une couche de silicium amorphe, cette dernière contenant facultativement de l'hydrogène.
